# EUROPEAN PATENT SPECIFICATION

(11) **EP 2 009 140 B1**
(45) Date of publication and mention of the grant of the patent: **02.03.2011**
(21) Application number: 07736994.0
(22) Date of filing: 29.03.2007
(51) Int. Cl.: C23C 16/509, C23C 16/24, H01L 31/04

(54) **METHOD FOR MICROCRYSTALLINE SILICON FILM FORMATION**
VERFAHREN ZUR BILDUNG EINES FILMS AUS MIRKOKRISTALLINEM SILICIUM
PROCÉDÉ POUR LA FORMATION D'UN FILM DE SILICUM MICROCRISTALLIN

(30) Priority: 29.03.2006 JP 2006092481
(43) Date of publication of application: 31.12.2008
(73) Proprietor: Ishikawajima-Harima Heavy Industries Co., Ltd., Tokyo 135-8710 (JP)
(72) Inventor: UEDA, Masashi, Tokyo 135-8710 (JP); TAKAGI, Tomoko, Tokyo 135-8710 (JP); ITOU, Norikazu, Tokyo 135-8710 (JP)
(74) Representative: Neugebauer, Jürgen
(86) International application number: PCT/JP2007/000337
(87) International publication number: WO 2007/111028

(56) References cited:
- JP-A- 10 139 413
- JP-A- 2000 068 520
- JP-A- 2002 069 653
- KOSKU N. ET AL.: 'High-rate deposition of highly crystallized silicon thin films from inductively coupled plasma' THIN SOLID FILMS vol. 435, 2003, pages 39 - 43, XP004431325
- TAKAGI T. ET AL.: 'Array Antenna-shiki Dai Menseki VHF-PCVD Sochi' OYO BUTUSURI vol. 71, no. 7, 2002, pages 874 - 877, XP003018133

## Description

### TECHNICAL FIELD

This invention relates to a microcrystalline silicon film forming method and a solar cell, especially to a microcrystalline silicon film forming method where a flow rate of hydrogen in material gas is reduced.

### BACKGROUND ART

Conventionally, amorphous silicon (a-Si) films formed by a plasma CVD (chemical vapor deposition) method have been used for large-area solar cells. However, a tandem-structure solar cell where a-Si film and a microcrystalline silicon (µc-Si) film are stacked to improve the conversion efficiency by effectively absorbing solar spectra ranging from infrared to ultraviolet, has been gathering much attention and partially commercialized.

This microcrystalline silicon film is formed mostly using a parallel-plate type (capacitive-coupling type) plasma CVD apparatus under a condition different from that for an a-Si film. In general, it is formed by supplying a RF (radio-frequency) power higher than that in a-Si film formation, under a higher hydrogen gas flow rate (i.e., higher hydrogen/silane flow ratio) than that in a-Si film formation. Specifically, compared to silane gas, a larger volume of hydrogen gas (e.g., not less than twenty times) is introduced to create a larger volume of hydrogen radicals required for crystallization, and a higher power is supplied to decompose hydrogen gas. Substrate temperature, which is preferably between 300 and 400°C in normal film formation, has to be lowered between 200 and 250°C when an underlying a-Si film has been already formed, such as in the tandem structure. Moreover, it has been pointed out that a much larger volume of hydrogen gas flow is required for crystallization when substrate temperature is lowered.

The plasma CVD apparatus releases toxic or dangerous gas such as unreacted or reacted gas of silane and hydrogen. Normally, the exhaust gas is diluted with an incombustible gas, such as nitrogen, to make the hydrogen gas concentration below the explosive limit. Then, it is released out to atmosphere after processing silane-series gases by an abatement system.
Patent Reference 1: Japanese Publication No.2003-158276
Patent Reference 2: Japanese Publication No.2004-143592
Non-patent Reference 1: Solar Energy Materials & Solar Cells, 62, 97-108(2000)
Non-patent Reference 2: Researches of the Electrotechnical Laboratory No.864, pp.46-57

KASCH N. ET AL.: 'High-rate deposition of highly crystallized silicon thin films from inductively coupled plasma' THIN SOLID FILMS vol. 435, 2003, pages 39 - 43 shows a method of making microcrystalline silicon thin films, as demonstrated by the intensity ratio between the Raman scattering peaks attributed to microcrystalline and amorphous silicon.

TAKAGI T. ET AL. : OYO BUTUSURI vol. 71, no. 7, 2002, pages 874 - 877 shows a plasma assisted CVD apparatus with an antenna array, which is used to produce microcrystalline silicon layers.

### DISCLOSURE OF THE INVENTION

### PROBLEM THE INVENTION WILL SOLVE

As described, nitrogen gas, which is comparatively cheap, has been normally used to dilute hydrogen gas. In forming a microcrystalline silicon film, however, cost of nitrogen gas could be a problem, because a large volume of hydrogen gas is used, and most of it is released out in an unreacted state. For example, when silane gas of 1 L/min. is used as material gas to fabricate a large-area solar cell, hydrogen gas of not less than 20 L(litters)/min. is required generally. Use of large-volume hydrogen gas requires a large-scale evacuation pump and increases the gas cost, boosting the total cost for a microcrystalline silicon solar cell. In addition, a large volume of nitrogen gas, i.e., 500 L/min., is required to dilute hydrogen gas of 20 L/min. in the exhaust gas below the explosive limit concentration (4%). This is another factor boosting the cost of the microcrystalline silicon solar cell.

For a solar cell with tandem structure, moreover, substrate temperature in forming a microcrystalline silicon film has to be approximately as low as in forming an amorphous silicon film. Therefore, the hydrogen gas flow rate has been much more increased, boosting the cost of the solar cell further.

In the situation as described, the inventors investigated many kinds of film formation methods and conditions thereof, not limited to the conventional parallel-plate-type plasma CVD, pursuing reduction of hydrogen gas flow rate. In this process, the inventors had discovered a method suiting for forming a microcrystalline silicon film. This method enables formation of a microcrystalline silicon film suiting for a solar cell even at a low flow rate of hydrogen gas. In this method, a multiplicity of antennas is disposed wholly covering a substrate to generate plasma, where one end of each antenna is connected to an high frequency power source, and another end of each antenna is grounded.

On a basis of this discovery, the invention had been completed by further investigation to realize stable formation of a microcrystalline silicon film suiting for a solar cell. That is, an object of the invention is to provide a plasma CVD method capable of forming a microcrystalline silicon film at a lower hydrogen gas flow rate and at a lower substrate temperature, compared to the prior art. A further object of the invention is to provide a method for producing a microcrystalline silicon solar cell at moderate price.

### MEANS FOR SOLVING THE PROBLEM

The method of this invention is one for forming a microcrystalline silicon film by a plasma CVD. In this method, plural inductive-coupling type antennas are arranged to form an antenna array structure in a vacuum chamber. One end of each antenna is connected to a high frequency power source and anther end is grounded. Substrates are placed facing the antenna array, and the substrate temperature is between150 and 250°C. Plasma is generated by introducing gas mixture of hydrogen and silane to the chamber, and by introducing high frequency power to the antennas. The high frequency power is in a range from 130 to 2786 w/m² per one substrate surface on which the film is deposites. When hydrogen/silane gas flow ratio is controlled in the range from 1 to 10, microcrystalline silicon films are formed on the substrates, with the ratio Ic/Ia between 2 and 6, whereas Ic is the Raman scattering intensity of a peak at around 520cm⁻¹ related to crystalline silicon, and Ia is the Raman scattering intensity at around 480cm⁻¹ related to amorphous silicon.

The microcrystalline silicon film produced by the method of this invention is one where the ratio Ic/Ia is between 2 and 6, whereas Ic and Ia are the Raman scattering intensity at around 520cm⁻¹ and at 480cm⁻¹, related to crystalline silicon and amorphous silicon, respectively. By combining this microcrystalline silicon film with an amorphous silicon film, it is enabled to fabricate a solar cell capable of more effective utilization of sun light in spite of being thin layers.
It is preferable to form the microcrystalline silicon film by controlling the hydrogen/silane gas flow ratio in range from 1 to 7.

In this invention, it is preferable that each antenna has a U-shaped configuration, with phase control between the antennas next to each other. By these, it is possible to form a microcrystalline silicon film having more uniform thickness distribution on a larger-area substrate, compared to, for example, a method using rod-shaped antennas.

In this invention, it is preferable to dispose three or more arrays of the antennas and cause a discharge in three or more regions simultaneously. In this case, two substrates are disposed between each array of the antennas, resulting in increase of the productivity. In addition, it is enabled to make the hydrogen gas flow rate much lower, compared to a method using one or two arrays of the antennas for one or two regions.

Further, the microcrystalline silicon film forming method of this invention is the method to fabricate microcrystalline silicon by inductively coupled plasma CVD method, comprising disposing substrates in a vacuum chamber, making temperature of the substrate between 150 and 250°C, introducing a gas mixture of hydrogen and silane, generating plasma by applying an high frequency power, controlling the hydrogen/silane gas flow ratio in a range from 1 to 10, and thus forming a microcrystalline silicon film on the substrate, wherein the ratio Ic/Ia of the film is between 2 and 6. It is further preferable to form a microcrystalline silicon film with hydrogen/silane gas flow ratio controlled in a range from 1 to 7.

### EFFECT OF THE INVENTION

Because the invention is by an inductively-coupled type plasma CVD, especially by an array-antenna type plasma CVD, it enables stable formation of a microcrystalline silicon film with a lesser hydrogen gas flow rate, compared to film formation by the parallel-plate type (capacitively-coupled type) plasma CVD. For example, even when substrate temperature is low, e.g., 200°C, it is possible to make the hydrogen/silane gas flow ratio not more than 10, further not more than 4. Although it has been impossible by the prior-art method, the invention enables to stably form a microcrystalline silicon film even under such a low hydrogen gas flow rate with the ratio Ic/Ia between 2 and 6, suitable to improve conversion efficiency of solar cells. As a result, it is enabled to reduce the cost of inert gas for diluting hydrogen and the apparatus cost drastically, which contributes to lowering prices of solar cells.

### BRIEF DESCRIPTION OF DRAWINGS

FIG.1 is a schematic cross-sectional view of a plasma CVD apparatus preferably used for the microcrystalline silicon film forming method of this invention.
FIG.2 is a schematic cross-sectional side view of the plasma CVD apparatus shown in FIG.1.
FIG.3 shows a graph on relation between crystallinity Ic/Ia of microcrystalline silicon and hydrogen/silane gas flow ratio.
FIG.4 shows a graph on relations between electric conductivity of microcrystalline silicon and hydrogen/silane gas flow ratio.

### DESCRIPTION OF NUMERALS

- 1: vacuum chamber
- 2: gas introduction port
- 3: exhaust port
- 4: material gas source
- 5: high frequency power source
- 7: 7 mechanical booster pump
- 8: 8 diluting gas source
- 9: rotary pump
- 10: 10 abatement system
- 11: antenna
- 12: high frequency power supply port
- 13: substrate
- 14: substrate holder
- 15: carrier
- 16: coaxial cable

### BEST MODE FOR CARRYING OUT THE INVENTION

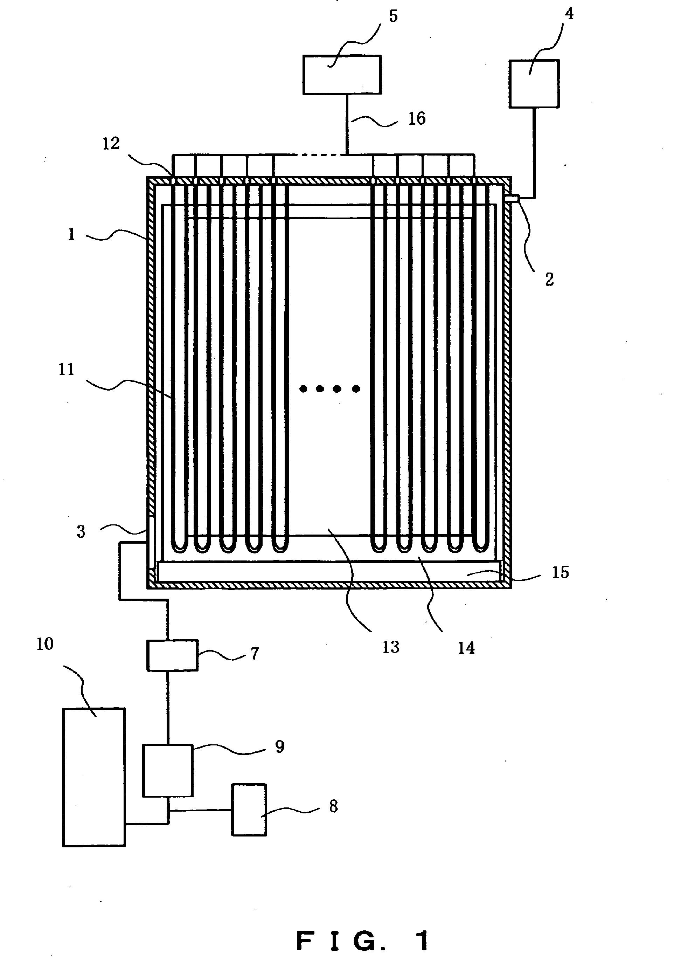

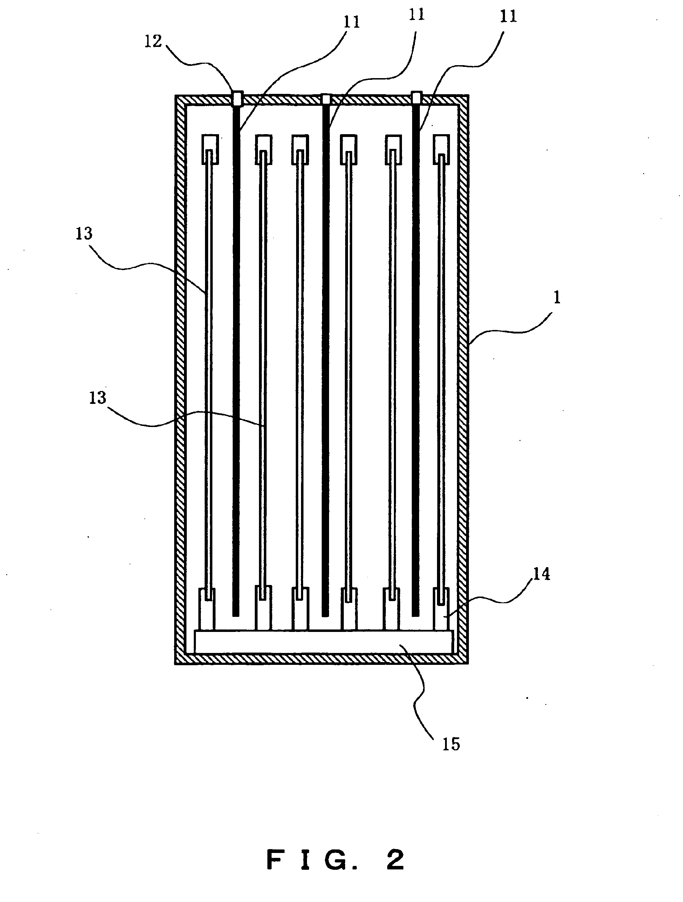

The microcrystalline silicon film formation method of this invention, which uses the plasma CVD apparatus shown in FIGs. 1 and 2, will be described as follows. FIG.1 shows a schematic cross-section in a view in the direction perpendicular to a transfer direction of substrates. FIG.2 shows a schematic cross section in a view in the transfer direction.

As shown in FIG.1, the plasma CVD apparatus comprises a vacuum chamber 1 having a gas introduction port 2 and an exhaust port 3, an antenna array where U-shaped curved antennas 11 are arranged in a plane in the chamber 1, an high frequency power source 5 applying an high frequency power to each antenna 11, a material gas source 4 connected to the gas introduction port 2, and a pumping device 7, 9 and a abatement system 10 connected to the exhaust port 3. An end of each antenna 11 (power apply port 12) is connected to the high frequency power source 5 by a coaxial cable 16. The other end of each antenna 11 is connected to a wall of the vacuum chamber 1 to be grounded. A multiplicity of the antennas 11 is disposed wholly covering the substrate 13. Each antenna 11 is apart from each other with a required distance. Each of the antenna arrays is disposed apart from each other with a required distance as well. Each substrate 13 is placed facing to each antenna array at both sides thereof. A heater (not shown) for heating the substrates is disposed on a wall of the vacuum chamber 1.

The material gas source comprises cylinders of silane gas and hydrogen gas, mass flow controllers and other components, so that the gases of required flow rates and flow ratio can be introduced into the vacuum chamber through the gas introduction port. Beside the material gas introduction structure shown in FIG.1, it is possible to employ, for example, hollow-structured antennas having gas diffusion holes. In this case, the material gas is introduced into each antenna from the grounded port thereof and then diffused into the vacuum chamber 1 through the diffusion holes.
The pumping device in the example of FIG.1 comprises a mechanical booster pump 7 and rotary pump 9. An exhaust port of the rotary pump 9 is connected with the abatement system 10. A nitrogen gas source for dilution is connected to a pipe interconnecting the rotary pump 9 and the abatement system 10.

A PIN-type a-Si/µc-Si tandem-type solar cell generally has the structure where p-type a-Si film, i-type a-Si film, n-type a-Si film, p-type µc-Si film, i-type µc-Si, n-type µc-Si film and backside electrode are formed in this order on a glass substrate having a transparent electrode thereon. As an example, a method for manufacturing a PIN-type a-Si/nc-Si tandem-type solar cell by the plasma CVD apparatus shown in FIG.1 is described as follows.

Opening a gate valve (not shown), a carrier 15 for the holders 14 holding the substrates 13 is transferred to the i-type µc-Si film formation room (vacuum chamber) 1. Each substrate 13 is placed facing to each antenna array. As shown in FIG.2, a pair of substrates 13 are placed interposing one antenna array. On each substrate 13. a p-type µc-Si film and other films have been already formed in another plasma CVD room. Closing the gate valve, the substrates 13 are heated and controlled to be at a temperature for µc-Si film formation, e.g., 200°C. From the material gas source 4, hydrogen and silane as the material gases are introduced into the vacuum chamber 1. The hydrogen/silane gas flow ratio is controlled in the range of 1 to 10 as pressure in the vacuum chamber 1 is controlled adequately. In this state, an high frequency power is applied to each antenna 11, thereby generating plasma. By these steps, discharge regions of the same number as of the antenna arrays are formed. An i-type µc-Si film is formed on each of the substrates 13 twice as many as the number of the discharge regions. Application of the high frequency power is stopped when each i-type µc-Si film grows to have a required thickness on each substrate 13.

By carrying out the described steps, it is possible to form the microcrystalline silicon film where the ratio Ic/Ia is 2 to 6, even when the substrate temperature is as low as 200 °C, and even when the hydrogen/silane gas flow ratio is as low as, e.g., 1. Therefore, the flow rate of nitrogen for dilution can be reduced drastically, which enables to reduce the cost for the solar cell manufacturing.
After forming the i-layers, i.e., i-type µc-Si films, the substrates 13 are transferred to a n-type µc-Si film forming apparatus, in which n-layers, i.e., n-type µc-Si films, are formed. Afterward, solar cells are completed by forming backside electrodes and other required components.

For improving uniformity of the plasma density, it is effective to form dielectric films on surfaces of the antennas, corresponding to the plasma density distribution. Otherwise, it is effective to coordinate thickness of each dielectric film or to vary diameter of the antennas, corresponding to the plasma density distribution. Moreover, the plasma density can be made more uniform on the whole area of each substrate 13 by controlling phase of the high frequency power applied to each antenna, specifically by controlling high frequency phase difference between the antennas neighboring to each other. By this, the homogeneitly of microcrystalline silicon film thickness and the film properties can be improved furthermore.

### EXAMPLE

The inventors had carried out concrete formation of silicon films under various conditions, and evaluated them regarding to crystallinity and photoelectrical property. In forming the silicon films, the same plasma CVD apparatus as shown in FIG.1 was used, except the gas introduction structure.
U-shaped antennas made of a stainless-steel pipes were used, with 8mm in diameter and with many gas diffusion holes (50mm in pitch) therein. The antenna was 1.6mm in length and the distance between the centers of two pipes were 35mm. Each antenna array was formed of twenty five antennas where the distance between the centers of adjacent pipes of the same side were 70mm. Three rows of the antenna array were disposed, from which the substrates were distant 35 mm.

Each gas introduction port was provided at the grounded port of each antenna in the plasma CVD apparatus used in this embodiment. A gas mixture of hydrogen and silane was introduced into the vacuum chamber from the gas diffusion holes of the antennas.
As the substrate, a 1.2 x 1.6 meters sized glass substrate was used. An 85 MHz source was used as the high frequency power source.

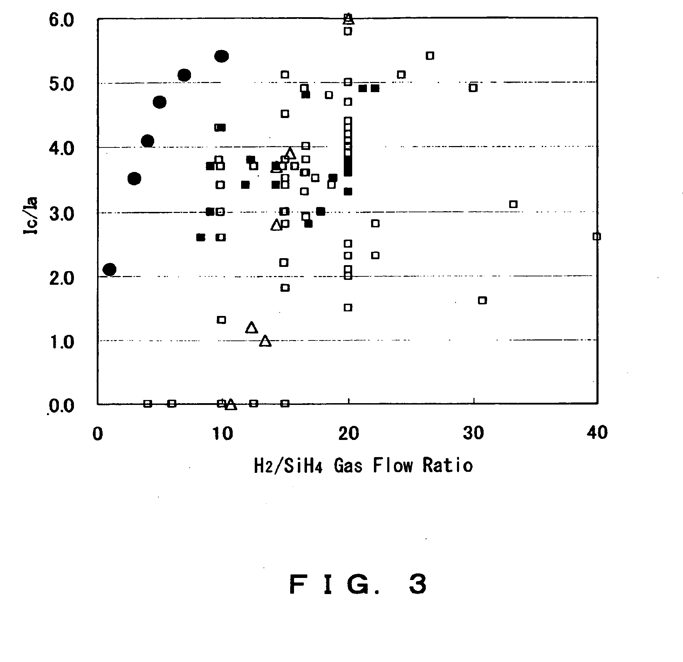

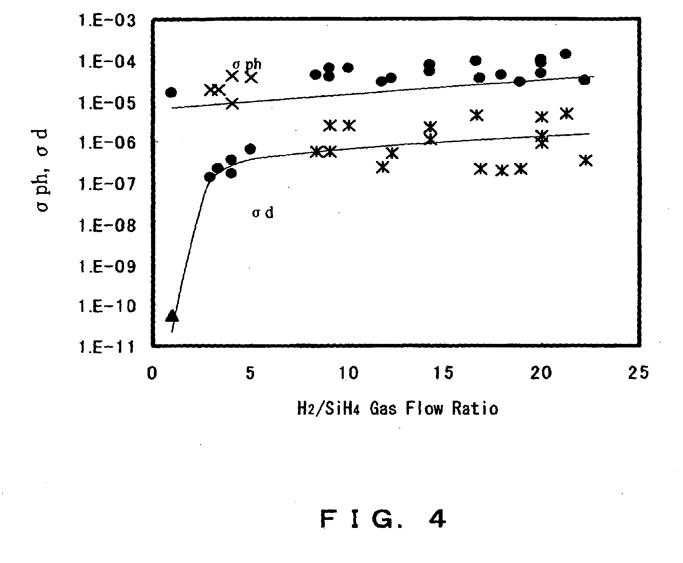

Film formation conditions were; the silane gas flow rate between 250 and 1,500 L/min., the hydrogen gas flow rate between 0 and 40,000 L/min., the hydrogen/silane gas flow ratio between 0 and 40, pressure between 2 and 29 Pa, the input power per one antenna between 20 and 428 W, and the substrate temperature between 150 and 250 °C. Varying the conditions in these ranges, silicon films were formed. On each sample, Raman spectra, photoelectric current and dark current were measured. These results are shown in FIGs. 3 and 4.

FIG.3 shows a graph on relation between the hydrogen/silane gas flow ratio and the ratio Ic/Ia. Ic is the Raman peak intensity at around 520 cm⁻¹ related to crystalline silicon, and Ia is the Raman peak intensity at 480 cm⁻¹ related to amorphous silicon. In FIG.3, • denotes a data when the plasma was generated in three regions by applying the high frequency power to all of three antenna arrays, Δ denotes a data when the plasma was generated in two regions by applying the high frequency power to two antenna arrays, and □ and ■ denote data when the plasma was generated in one region by applying the high frequency power to one antenna array.

When the flow ratio was 10 or below, formation of microcrystalline silicon having the Ic/Ia between 2 and 6 was rather difficult, as same as in the case of parallel-plate type plasma CVD apparatus. On the other hand, the result shown in the figure demonstrates formation of microcrystalline silicon even when the flow ratio was 10, further even 1. Although the reason has not been clear, a microcrystalline silicon film can be formed at a lesser hydrogen gas flow rate when the number of the discharge region is three.

FIG.4 shows relations between photo-and-dark electric conductivities σph, σd and the gas flow ratio. Values of the photoelectric conductivity σph were under 100 mW/cm² irradiation at 1.5 AM (Air Mass). Comparing FIG.3 and FIG.4, it is known that the ratios σph/ σd of the microcrystalline silicon having the ratio Ic/Ia between 2 and 6 are all approximately 100, and that microcrystalline silicon films preferred for solar cells were formed.

Although the above description was on the PIN type solar cell having the tandem structure of an a-Si film and µc-Si film, the invention is not limited to this. Beside the PIN type, the invention can be applied to formation of microcrystalline silicon films of any types for PN type solar cells, Schottky type solar cells and others.

## Claims

1. A method for forming a microcrystalline silicon film by a plasma CVD method, comprising
arranging a substrate and inductive-coupling type antennas in a vacuum chamber;
making an array of the antennas in a plane to form an array antenna structure;
arranging the substrate facing to the array of the antennas;
setting the temperature of the substrate between 150 and 250°C;
introducing a mixture of gas including hydrogen and silane;
applying high frequency power to the antennas, thereby generating plasma;
controlling a hydrogen/silane gas flow ratio in a range from 1 to 10; and
forming a microcrystalline silicon film on the substrate;
wherein the high frequency power is between a range from 130 to 2786 W/m² per one substrate surface on which the film is deposited, and ratio of Ic/Ia of the film is between 2 and 6;
whereas Ic is a Raman scattering intensity of a peak at around 520cm⁻¹ related to crystalline silicon, and Ia is a Raman scattering intensity at around 480cm⁻¹ related to amorphous silicon.

2. A method for forming a microcrystalline silicon film as claimed in claim 1, wherein the hydrogen/silane gas flow ratio is controlled in a range from 1 to 7.

3. A method for forming a microcrystalline silicon film as claimed in claim 1 or 2, further comprising
connecting one end of each antenna to a high frequency power source, and the other end to the ground; and
controlling the phase difference between antennas next to each other.

4. A method for forming a microcrystalline silicon film as claimed in claim 1, 2 or 3, further comprising
arranging plural arrays of the antennas; and
arranging two substrates at both sides of each array of the antennas.

5. A method for forming a microcrystalline silicon film as claimed in claim 4, further comprising
arranging three or more arrays of the antennas; and
generating discharge in three or more regions simultaneously.

## Patentansprüche

1. Verfahren zur Bildung eines Films aus mikrokristallinem Silicium nach einem Plasma-CVD-Verfahren, mit den folgenden Schritten:
Anordnen von einem Substrat und Antennen vom induktiven Kopplungstyp in einer Vakuumkammer;
Herstellen eines Arrays der Antennen in einer Ebene, um eine Array-Antennenstruktur zu bilden;
Anordnen des Substrats gegenüber dem Array der Antennen;
Einstellen der Temperatur des Substrats zwischen 150 und 250°C;
Einleiten einer Gasmischung, die Wasserstoff und Silan enthält;
Anlegen hochfrequenter Energie an die Antennen, wodurch Plasma erzeugt wird;
Steuern eines Wasserstoff/Silan-Verhältnisses der Gasströmung in einem Bereich von 1 bis 10; und
Bilden eines Films aus mikrokristallinem Silicium auf dem Substrat;
wobei die hochfrequente Energie in einem Bereich von 130 bis 2786 W/m² pro einer Substratoberfläche, auf welcher der Film abgeschieden wird, liegt und wobei ein Verhältnis von Ic/la des Films zwischen 2 und 6 liegt;
wobei Ic eine Raman-Streuintensität mit einem Peak bei etwa 520 cm⁻¹ ist, bezogen auf kristallines Silicium, und la eine Raman-Streuintensität bei etwa 480 cm⁻¹ ist, bezogen auf amorphes Silicium.

2. Verfahren zur Bildung eines Films aus mikrokristallinem Silicium nach Anspruch 1, wobei das Wasserstoff/Silan-Verhältnis der Gasströmung in einem Bereich von 1 bis 7 gesteuert wird.

3. Verfahren zur Bildung eines Films aus mikrokristallinem Silicium nach Anspruch 1 oder 2, das ferner die folgenden Schritte umfasst:
Verbinden eines Endes jeder Antenne mit einer hochfrequenten Energiequelle und des anderen Endes mit Erde; und
Steuern der Phasendifferenz zwischen benachbarten Antennen.

4. Verfahren zur Bildung eines Films aus mikrokristallinem Silicium nach Anspruch 1, 2 oder 3, das ferner die folgenden Schritte umfasst:
Anordnen von mehreren Arrays der Antennen; und
Anordnen von zwei Substraten auf beiden Seiten jedes Arrays der Antennen.

5. Verfahren zur Bildung eines Films aus mikrokristallinem Silicium nach Anspruch 4, das ferner die folgenden Schritte umfasst:
Anordnen von drei oder mehr Arrays der Antennen; und
Erzeugen einer Entladung in drei oder mehr Bereichen gleichzeitig.

## Revendications

1. Procédé de formation d'un film de silicium microcristallin selon un processus de dépôt chimique à partir d'une phase vapeur (CVD), assisté par plasma, lequel procédé comporte les étapes suivantes :
- placer dans une enceinte à vide un substrat et des antennes du type à couplage par induction ;
- disposer les antennes en réseau dans un plan, pour en faire une structure qui est un réseau d'antennes ;
- disposer le substrat face à ce réseau d'antennes ;
- porter le substrat à une température située entre 150 et 250 °C ;
- introduire un mélange de gaz comprenant de l'hydrogène et un silane ;
- apporter aux antennes une énergie haute fréquence, de manière à produire un plasma ;
- ajuster le rapport des débits de gaz hydrogène/silane à une valeur située dans l'intervalle allant de 1 à 10 ;
- et former un film de silicium microcristallin sur le substrat ;
et dans lequel procédé l'énergie haute fréquence se situe dans l'intervalle allant de 130 à 2786 watts par mètre carré de surface de substrat sur quoi se dépose le film, et le rapport Ic/Ia du film vaut de 2 à 6, Ic étant l'intensité de diffusion Raman au niveau du pic situé vers 520 cm⁻¹, attribuée au silicium cristallin, et Ia étant l'intensité de diffusion Raman vers 480 cm⁻¹, attribuée au silicium amorphe.

2. Procédé de formation d'un film de silicium microcristallin, conforme à la revendication 1, dans lequel on ajuste le rapport des débits de gaz hydrogène/silane à une valeur située dans l'intervalle allant de 1 à 7.

3. Procédé de formation d'un film de silicium microcristallin, conforme à la revendication 1 ou 2, qui comporte en outre :
- le fait de connecter une extrémité de chaque antenne à une source d'énergie haute fréquence et l'autre extrémité à la terre ;
- et le fait d'ajuster le déphasage entre antennes, de chacune d'elles à la suivante.

4. Procédé de formation d'un film de silicium microcristallin, conforme à la revendication 1, 2 ou 3, qui comporte en outre :
- le fait de disposer plusieurs réseaux d'antennes ;
- et le fait de placer deux substrats des deux côtés de chaque réseau d'antennes.

5. Procédé de formation d'un film de silicium microcristallin, conforme à la revendication 4, qui comporte en outre :
- le fait de disposer trois réseaux d'antennes ou plus ;
- et le fait de produire une décharge de façon simultanée dans trois régions ou plus.
